# EUROPEAN PATENT SPECIFICATION

(11) **EP 2 043 162 B1**
(45) Date of publication and mention of the grant of the patent: **08.01.2014**
(21) Application number: 08253158.3
(22) Date of filing: 26.09.2008
(51) Int. Cl.: H01L 31/048, H01L 31/0216

(54) **Solar cell module**
Solarzellenmodul
Module de cellule solaire

(30) Priority: 28.09.2007 JP 2007253275
(43) Date of publication of application: 01.04.2009
(73) Proprietor: Asahi Fiber Glass Company, Limited, Tokyo 101-0045 (JP)
(72) Inventor: Higashiyama, Hideyuki c/o Asahi Fiber Glass Company Ltd., Tokyo 1010045 (JP); Sekine, Keiji c/o Asahi Fiber Glass Company Limited, Chiyoda-ku Tokyo 1010045 (JP)
(74) Representative: Beacham, Annabel Rose

(56) References cited:
- WO-A2-02/31053
- JP-A- 2002 231 990
- US-A1- 2007 112 123

## Description

### BACKGROUND OF THE INVENTION

### 1. Field of the Invention

The present invention relates to a solar cell module, and more particularly, to a solar cell module which has a light weight and is capable of being molded in a free shape.

### 2. Description of the Related Art

Conventionally, solar cell modules have a transparent cover material arranged on a surface into which the sunlight enters and a rear substrate arranged on a side opposite to the surface into which the sunlight enters. A transparent filler is filled between the transparent cover material and the rear substrate. Solar cells are arranged in the filler, and the cells are connected with each other through lead wires.

As the transparent cover material, a tempered glass having high transmittance to sunlight and relatively excellent mechanical strength has been employed. As a cover material formed of glass, Japanese Patent Application Laid-open No. 2000-226228 discloses a cover material for a solar cell which has such a glass characterized in that the material can be formed in a microsheet by stretching and has substantially a composition of, expressed in terms of oxides in wt%, 56 to 69% of SiO₂, 6.5 to 8.5% of ZnO, 8.5 to 14% of B₂O₃, 0.25 to 3% of CeO₂, 2 to 2.5% of Al₂O₃, 0 to 1% of TiO₂, 5.5 to 12.5% of Na₂O, 0.5 to 4% of CeO₂ + TiO₂, 0 to 8% of K₂O, and 0 to 0.5% of Sb₂O₃.

In addition, a transparent resin sheet has also been studied in recent years with a view to reducing the weight. For example, Japanese Patent Application Laid-open No. 2005-277187 discloses a solar cell module including a front surface cover member provided on a side into which the sunbeam enters, a rear surface cover member provided on a side opposite to the side which the sunbeam enters so as to face the front surface cover member, the rear surface cover being formed of the same material as that of the front surface cover member, a fillingmember filledbetween the front surface cover member and the rear surface cover member, and a solar cell body provided in the filling member so as to be sealed by the filling member, in which the front surface cover member and the rear surface cover member are each formed of any one of polycarbonate, polyethylene, and polyethylene terephthalate.
However, the cover glass for a solar cell disclosed in Japanese Patent Application Laid-Open No. 2000-226228 is relatively heavy compared to a cover member formed of a resin material, and hence the cover glass has disadvantages in promoting reduction of weight when mounted on a vehicle as an exterior device, for instance. In addition, a glass material has disadvantages in mass production, because when the glass material is molded in a curved shape, the heating step for the glass material is more complicated than that for a resin material, and careful handling is required to prevent the glass material from cracking.

On the other hand, a resin material such as polycarbonate, polyethylene, or polyethylene terephthalate is used in the front surface cover member and rear surface cover member of the solar cell module disclosed in Japanese Patent Application Laid-open No. 2005-277187. The resin material has a linear expansion coefficient of about 7 to 11 (× 10⁻⁵/°C), and hence there may be problems, particularly when the resin material is incorporated in an exterior material of a vehicle, in that a gap occurs in a boundary portion to the steel plate due to the difference between the linear expansion coefficient of the resin material and that of the steel plate, or the exterior material cannot absorb and resist deflection, resulting in a flaw.

JP-A 2002-231990 discloses solar battery panels comprising a solar cell between front and rear surface cover members formed of glass-filler containing thermoplastic resin.

### SUMMARY OF THE INVENTION

Therefore, an object of the present invention is to provide a solar cell module, which can be reduced in thickness and weight, is applicable to a curve shape, and can be applied to an exterior material or the like of a vehicle.

The inventors of the present invention extensively studied with a view to solving the above-mentioned problems. As a result, the inventors found that a glass filler-containing thermoplastic resin molded product, which has high transparency, and is excellent in stiffness, heat resistance, and weather resistance, could be obtained by molding a glass filler-containing resin composition including a glass filler having a specific glass composition and a thermoplastic resin. The inventors also found that the glass filler-containing thermoplastic molded product is suitable for a cover member of the solar cell module, and the present invention was thus completed.

That is, the present invention provides a solar cell module including a front surface cover member provided on a side into which sunlight enters, a rear surface cover member provided on a side opposite to the side into which sunlight enters to face the front surface cover member, and a solar cell provided between the front surface cover member and the rear surface cover member, in which the front surface cover member and the rear surface cover member are each formed of a glass filler-containing thermoplastic resin molded product; characterized in that:
the front surface cover member (2) comprises a glass filler-containing amorphous polyamide resin molded product including an amorphous polyamide resin and a glass filler, and having a difference in refractive indices between the amorphous polyamide resin and the glass filler of 0.002 or less with respect to light having a wavelength of 589 nm, and
wherein the glass filler in the glass filler-containing amorphous polyamide resin molded product in the front surface cover member (2) has a glass composition comprising, expressed in terms of oxides by mass%, 68 to 74% of silicon oxide (SiO₂), 2 to 5% of aluminum oxide (Al₂O₃), 2 to 5% of boron oxide (H₂O₃), 2 to 10% of calcium oxide (CaO), 0 to 5% of zinc oxide (ZnO), 0 to 5% of strontium oxide (SrO), 0 to 1% of barium oxide (BaO), 0 to 5% of magnesium oxide (MgO), 0 to 5% of lithium oxide (Li₂O), 5 to 12% of sodium oxide (Na₂O), and 0 to 10% of potassium oxide (K₂O), where:
   a total content of the Calcium oxide (CaO), the zinc oxide (ZnO), the strontium oxide (SrO), and the barium oxide (BaO) is 4 to 10%; and
   a total content of the lithium oxide (Li₂O), the sodium oxide (Na₂O), and the potassium oxide (K₂O) is 8 to 12%. The front surface cover member should have a parallel light transmittance of 65% or higher and a haze of less than 30%.

According to the present invention, the solar cell module is thin, light, and easily molded in a curve shape, and has excellent stiffness, heat resistance, and weather resistance because the front surface cover member and the rear surface cover member are each formed of a glass filler-containing thermoplastic resin molded product. In addition, the front surface cover member has a parallel light transmittance of 65% or higher and a haze of less than 30%, so sunlight can be favorably transmitted through the front surface cover member to irradiate the solar cell.

In the present invention, the glass filler-containing thermoplastic resin molded product preferably has a linear expansion coefficient of 3.0 to 6.0 (x 10⁻⁵/°C). With the linear expansion coefficient being in this preferred range, the following problems can be prevented: when the molded product is incorporated in an exterior material of a vehicle, for Example, a gap occurs in a boundary portion to the steel plate due to the difference between the linear expansion coefficient of the molded product and that of the steel plate, or the exterior material cannot absorb and resist deflection, resulting in a flaw and the like.

The front surface cover member is a glass filler-containing amorphous polyamide resin molded product including an amorphous polyamide resin and a glass filler, and having a difference between the refractive index of the amorphous polyamide resin and the refractive index of the glass filler of 0.002 or less with respect to light having a wavelength of 589 nm. With this constitution, the front surface cover member has high transparency, and has excellent stiffness, heat resistance, and weather resistance.

In this case, the rear surface cover member also preferably is the glass filler-containing amorphous polyamide resin molded product including the amorphous polyamide resin and the glass filler. With this constitution, the front surface cover member and the rear surface cover member have the same linear expansion coefficient, whereby warp of the solar cell module and the like can be prevented.

In addition, the glass filler in the glass filler-containing amorphous polyamide resin molded product has a glass composition comprising (or consisting of), expressed in terms of oxides by mass%, 68 to 74% of silicon oxide (SiO₂), 2 to 5% of aluminum oxide (Al₂O₃), 2 to 5% of boron oxide (B₂O₃), 2 to 10% of calcium oxide (CaO), 0 to 5% of zinc oxide (ZnO), 0 to 5% of strontium oxide (SrO), 0 to 1% of barium oxide (BaO), 0 to 5% of magnesium oxide (MgO), 0 to 5% of lithium oxide (Li₂O), 5 to 12% of sodium oxide (Na₂O), and 0 to 10% of potassium oxide (K₂O), where:
a total content of the calcium oxide (CaO), the zinc oxide (ZnO), the strontium oxide (SrO), and the barium oxide (BaO) is 4 to 10%; and
a total content of the lithium oxide (Li₂O), the sodium oxide (Na₂O), and the potassium oxide (K₂O) is 8 to 12%.

With the above composition, a glass filler-containing amorphous polyamide resin molded product having a difference between a refractive index of the amorphous polyamide resin and a refractive index of the glass filler of 0.002 or less with respect to light having a wavelength of 589 nm can be readily obtained.

The solar cell module of the present invention has a relatively low linear expansion coefficient, and excellent stiffness, heat resistance, and weather resistance, thereby being preferably used as an exterior device for vehicles.

### BRIEF DESCRIPTION OF THE DRAWINGS

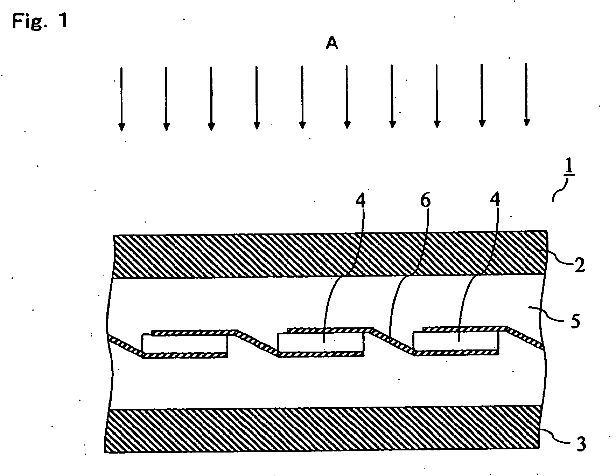

FIG. 1 shows in schematic form a solar cell module of the present invention.

### DETAILED DESCRIPTION OF THE PREFERRED EMBODIMENTS

According to the present invention, a thin, light solar cell module applicable to a curve shape can be obtained by using a glass filler-containing thermoplastic resin molded.product having excellent transparency, mechanical strength, and heat resistance as a front surface cover material of the solar cell module. The solar cell module can be preferably used for dwellings, various landscape purpose, loading on automobiles, and the like.

### (Whole constitution)

As shown in FIG. 1, a solar cell module 1 has a front surface cover member 2 provided on a light receiving side (front side) into which sunlight enters and a rear surface cover member 3 provided on a side opposite to the light receiving side (rear side) . A solar cell 4 is provided between the front surface cover member 2 and the rear surface cover member 3. The solar cells 4 are sealed with a filler 5 such as an ethylene-vinyl acetate copolymer resin (EVA resin) . Note that the solar cells are connected to each other with interconnectors 6.

Materials formed of substantially the same components are used to form the front surface cover member 2 and the rear surface cover member 3. In the present invention, a glass filler-containing thermoplastic resin molded product is used to form the members. The front surface cover member employs the glass filler-containing amorphous polyamide resin molded product having transparency in order to transmit sunlight. It is required for the front surface cover member to have a parallel light transmittance of 65% or higher and a haze of less than 30%. Although the wavelength range showing good power generation efficiency varies depending on the raw material of the solar cell, the parallel light transmittance is required to be 65% or higher at a wavelength from a visible ray region to a near infrared rayregion, i.e., 400nm to 1,100nm. It is preferred that the parallel light transmittance be 70% or higher and the haze be less than 25%. With the parallel light transmittance and haze, the light quantity needed for photovoltaic power generation can be secured, and a solar cell module being thin, light, and capable of being molded in a curve shape, which are characteristics of the glass filler-containing thermoplastic resin molded product, can be obtained.

In addition, the glass filler-containing thermoplastic resin molded product preferably has a linear expansion coefficient of 3.0 to 6.0 (× 10⁻⁵/°C). By using a molded product having a specific linear expansion coefficient, the linear expansion coefficient: of the solar cell module can be kept low, and any difference in the linear expansion coefficients between the solar cell module and a peripheral member can be minimised. In particular, when the solar cell module is incorporated in an exterior material of a vehicle, flexure and distortion of the solar cell module can be suppressed.

### (First embodiment of glass filler-containing thermoplastic resin molded product)

In the present invention, a glass filler-containing amorphous polyamide resin molded product including an amorphous polyamide resin and a glass filler, and having a difference of refractive indices between the amorphous polyamide resin and the glass filler of 0. 002 or less with respect to light having a wavelength of 589 nm, is used as the glass filler-containing thermoplastic resin molded product in the front surface cover member (2) and optionally also in the rear surface cover member (3). The glass filler-containing amorphous polyamide resin molded product has transparency, is thin and light, and is capable of being molded into a curved shape, and furthermore, has excellent weather resistance, so an excellent front surface cover member can be provided. The glass filler-containing amorphous polyamide resin molded product is obtained by molding a resin component comprising an amorphous polyamide resin and a resin composition comprising a glass filler. Hereinafter, the glass filler-containing amorphous polyamide resin molded product is described in detail.

### (Amorphous polyamide resin component)

The resin component comprising the amorphous polyamide resin to be used in the present invention is not particularly limited as long as the component contains an amorphous polyamide resin having transparency. From materials that constitute polyamide resins, by selecting a material monomer having an asymmetric chemical structure, transparent amorphous polyamide resins can be obtained. The resin component containing the amorphous polyamide resin may be a single amorphous polyamide resin or a polymer alloy of an amorphous polyamide resin containing a polyamide resin, a polyolefin resin, a polystyrene resin, a thermoplastic elastomer, a rubber component, or the like, as long as the transparency is not impaired.

Examples of kinds of the amorphous polyamide resin include Polyamide PA12/MACMI (PA12/3,3-dimethyl-4,4-diaminocyclohexyl methane, isophthalic acid), PA12/MACMT (PA12/3,3-dimethyl-4,4-diaminocyclohexyl methane, terephthalic acid), PA MACM 12 (3,3-dimethyl-4,4-diaminocyclohexylmethane, decanedicarboxylic acid or laurolactam), PA MC 12 (PA12, 1,3-bis(aminomethyl)cyclohexane), PA6I/6T, and PA6I/6T/MACMI. It should be noted that the notations of the polyamide resins are in accordance with JIS K6920-1.

In the present invention, as the resin component containing an amorphous polyamide resin, those available in the market such as "Grilamide TR55"containing PA12/MACMI (trade name, manufactured by EMS-Chemie), "Grilamide TR90" containing PAMACM 12 (trade name, manufactured by EMS-Chemie), and "Trogamide CX" (trade name, manufactured by Evonik Degussa-Chemie) containing PA MC 12, "CRISTAMID MS" containing PA12/MACMT (trade name, manufactured by ARKEMA), and "Rilsan M-G350" containing PA MACM 14 (trade name, manufactured by ARKEMA) may be given.

The refractive indices of the resin component containing the amorphous polyamide resin are preferably 1.505 to 1. 545 with respect to light having a wavelength of 589 nm, 1.512 to 1.555 with respect to light having a wavelength of 486 nm, and 1. 502 to 1.541 with respect to light having a wavelength of 656 nm. In particular, in order to decrease the difference in the refractive indices between the resin component and the glass filler, the refractive indices of the resin component containing the amorphous polyamide resin are particularly preferably: 1.508 to 1.520 with respect to light having a wavelength of 589 nm; 1.515 to 1.527 with respect to light having a wavelength of 486 nm; and 1.505 to 1.517 with respect to light having a wavelength of 656 nm. Preferable examples of the resin components having the above-mentioned refractive indices include "Grilamid TR90" (trade name, manufactured by EMS-CHEMIE, the refractive index with respect to light having a wavelength of 589 nm: 1.509, the refractive index with respect to light having a wavelength of 486 nm: 1.516, the refractive index with respect to light having a wavelength of 656nm: 1.506) and "RilsanM-G350" (trade name, manufactured by ARKEMA, the refractive index with respect to light having a wavelength of 589 nm: 1.507, the refractive index with respect to light having a wavelength of 486 nm: 1.514, the refractive index with respect to light having a wavelength of 656 nm: 1.504).

### (Glass filler used in glass filler-containing amorphous polyamide resin molded product)

The glass filler used in the glass f iller-containing amorphous polyamide resin molded product of the present invention has a composition comprising, expressed in terms of oxides by mass%, 68 to 74% of silicon oxide (SiO₂), 2 to 5% of aluminum oxide (Al₂O₃), 2 to 5% of boron oxide (B₂O₃), 2 to 10% of calcium oxide (CaO), 0 to 5% of zinc oxide (ZnO), 0 to 5% of strontium oxide (SrO), 0 to 1% of barium oxide (BaO), 0 to 5% of magnesium oxide (MgO), 0 to 5% of lithium oxide (Li₂O), 5 to 12% of sodium oxide (Na₂O), and 0 to 10% of potassium oxide (K₂O), where a total amount of lithium oxide (Li₂O), sodium oxide (Na₂O), and potassium oxide (K₂O) is 8 to 12%. Hereinafter, the composition of the glass filler is described ("mass%" is simply referred to as "%").

The glass filler contains silicon oxide (SiO₂) at a concentration of 68 to 74%, and preferably 68 to 72%. It the silicon oxide (SiO₂) content is less than 68%, it is difficult to match the refractive indexof the glass filler to that of the amorphous polyamide resin. On the otherhand, if the silicon oxide (SiO₂) content exceeds 74%, solubility of the glass filler in production thereof is lowered and in the case where a glass fiber is used as the glass filler, the spinning temperature is raised, resulting in difficulty in production.

The glass filler contains aluminum oxide (Al₂O₃) at a concentration of 2 to 5%, and preferably 2 to 4%. If the aluminum oxide (Al₂O₃) content is less than 2%, chemical resistance such as water resistance may deteriorate. On the other hand, if the aluminum oxide (Al₂O₃) content exceeds 5%, the glass tends to be heterogeneous because of lowered solubility in production of the glass filler.

The total content of silicon oxide (SiO₂) and aluminum oxide (Al₂O₃) is preferably 70 to 79%, and more preferably 71 to 76%. If the content is within the ranges, it is easy to approximate the refractive index of the glass filler to the refractive index of the amorphous polyamide resin.

The glass filler contains sodium oxide (Na₂O) at a concentration of 5 to 12%, preferably 5 to 11%, further preferably 8 to 10%. If the sodium oxide (Na₂O) content exceeds 12%, water resistance of the glass tends to decrease. On the other hand, if the sodium oxide (Na₂O) content is less than 5%, it is difficult to approximate the refractive index of the glass filler to the refractive index of the amorphous polyamide resin.

The glass filler may contain lithium oxide (Li₂O) at a concentration of 0 to 5%, and preferably 0 to 2%. The glass filler may contain potassium oxide (K₂O) at a concentration of 0 to 10%, and preferably 0 to 5%. Sodium oxide (Na₂O) may partially be substituted by lithium oxide (Li₂O) or potassium oxide (K₂O), whereby it is possible to improve the water resistance of the glass.

The glass filler contains such alkaline components, lithium oxide (Li₂O), sodium oxide (Na₂O), and potassium oxide (K₂O), at a concentration of 8 to 12%, and preferably 8 to 11% in total.

If the total amount of the alkaline components exceeds 12%, water resistance of the glass tends to decrease. On the other hand, a total amount of the alkaline components of less than 8% is not preferred because the glass is difficult to melt in production of the glass filler, and in the case where the glass fiber is used as the glass filler, it is difficult to spin the glass fiber.

The glass filler contains calcium oxide (CaO) at a concentration of 2 to 10%, and preferably 6 to 9%. If the calcium oxide (CaO) content is less than 2%, the meltability of the glass tends to be lowered. On the other hand, if the calcium oxide (CaO) content exceeds 10%, it is difficult to approximate the refractive index of the glass filler to the refractive index of the amorphous polyamide resin.

zinc oxide (ZnO) is an optional component, and the glass filler may contain zinc oxide at a concentration of 0 to 5%, and preferably 0 to 2%. Addition of zinc oxide (ZnO) can improve the water resistance of the glass. However, a zinc oxide (ZnO) content exceeding the upper limit is not preferred because the glass tends to be prone to devitrification.

Strontium oxide (SrO) is an optional component, and the glass filler may contain strontium oxide at a concentration of 0 to 5%, and preferably 0 to 2%.

Barium oxide (BaO) is an optional component, and the glass filler may contain barium oxide at a concentration of 0 to 1%.

The total content of calcium oxide (CaO), zinc oxide (ZnO), strontium oxide (SrO), and barium oxide (BaO) is 4 to 10%, and more preferably 6 to 10%. If the total content of these components is less than 4%, the meltability of the glass may be lowered. On the other hand, if the content exceeds 10%, it is difficult to approximate the refractive index of the glass filler to the refractive index of the amorphous polyamide resin.

The glass filler contains magnesium oxide (MgO) at a concentration of 0 to 5%, preferably 1 to 5%, and further preferably 1 to 3%. Addition of magnesium oxide (MgO) can improve the mechanical properties of the glass. A magnesium oxide (MgO) content exceeding 5% is not preferred because the meltability of the glass tends to be lowered.

The glass filler contains boron oxide (B₂O₃) at a concentration of 2 to 5%, and preferably 2 to 4%. A boron oxide (B₂O₃) content of less than 2% is not preferred because it is difficult to approximate the refractive index of the glass filler to the refractive index of the amorphous polyamide resin. A boron oxide (B₂O₃) content exceeding 5% is not preferred because volatilization tends to occur during glass melting, which may increase corrosion of facilities for production due to volatile components or may require the equipment for collecting the volatile components.

If titanium oxide (TiO₂) is contained in the glass filler used in the present invention, the glass filler is colored brown, and the obtained molded product is colored yellow. Accordingly, because there is concern that the transmittance to visible light is lowered, and hence power generation efficiency may be lowered, it is preferred that the glass filler be substantially free of titanium oxide (TiO₂). The phrase "substantially free of titanium oxide (TiO₂)" means "purposely free of titanium oxide except when titanium oxide is contained as impurities from industrial materials", i . e. , the TiO₂ content is less than 0.05%.

The glass filler of the present invention may contain one or more component (s) other than the above-mentioned components as long as the effect of the present invention is not impaired. For example, the glass filler may contain an oxide of a metal such as Fe, Co, Ni, Sn, Zr, or Mo as a component of the glass composition.

A glass filler having the above-mentioned composition has a refractive index of 1.505 to 1.545 with respect to light having a wavelength of 589 nm, a refractive index of 1. 512 to 1. 555 with respect to light having a wavelength of 486 nm, and a refractive index of 1.502 to 1.541 with respect to light having a wavelength of 656 nm, and the refractive indices are almost the same as those of the amorphous polyamide resin. Therefore, the glass filler can be used for producing an amorphous polyamide resin molded product having high transparency and excellent mechanical strength. In addition, the melting temperature of the glass is 1, 500 to 1, 600°C, and therefore, the glass filler can be formed into a filler shape as in the case of the E-glass composition.

For example, if the composition of the glass filler is set to 68 to 72% of silicon oxide (SiO₂), 2 to 4% of aluminum oxide (Al₂O₃), 2 to 4% of boron oxide (B₂O₃), 6 to 9% of calcium oxide (CaO), 0 to 2% of zinc oxide (ZnO), 0 to 2% of strontium oxide (SrO), 0 to 1% of barium oxide (BaO), 1 to 3% of magnesium oxide (MgO), 0 to 2% of lithium oxide (Li₂O), 8 to 11% of sodium oxide (Na₂O), and 0 to 5% of potassium oxide (K₂O), the glass filler tends to have a refractive index of 1.508 to 1.520 with respect to light having a wavelength of 589 nm, a refractive index of 1.515 to 1.527 with respect to light having a wavelength of 486 nm, and a refractive index of 1.505 to 1.517 with respect to light having a wavelength of 656 nm.

As described above, siliconoxide (SiO₂), aluminumoxide (Al₂O₃), and alkaline components can decrease the refractive index of the glass filler. Examples of a component that can decrease the refractive index of glass filler other than the above-mentioned components include P₂O₅ and F_{2.}

Therefore, in the case where the refractive index of the glass filler is smaller than a desired refractive index, that is, the refractive index of the amorphous polyamide resin, the refractive index can be raised by, for example, substituting calcium oxide (CaO) for part of the silicon oxide (SiO₂) content. Specifically, for example, if 0.4% of calcium oxide (CaO) is substituted for 0.4% of silicon oxide (SiO₂), the refractive index of the glass filler increases by about 0.002.

In the case where the refractive index of the glass filler is larger than a desired refractive index, that is, the refractive index of the amorphous polyamide resin, the refractive index can be lowered by, for example, substituting an alkaline component for part of calcium oxide (CaO) content. Specifically, for example, if 0.8% of sodium oxide (Na₂O) is substituted for 0.5% of calcium oxide (CaO), the refractive index of the glass filler decreases by about 0.002.

As described, if a component capable of raising the refractive index of the glass filler and a component capable of lowering the refractive index of the glass filler are separately and appropriately substituted without departing from the scope of the present invention, the refractive index of the glass filler canbe appropriately adjusted, and it is possible to produce a glass filler having the same range of refractive index as that of the refractive index of the amorphous polyamide resin.

### (Supplementary explanation of glass filler)

In the present invention, at least one selected from a glass fiber, a glass flake, a milled fiber, a glass powder, a glass bead, and a glass balloon is preferably used as a glass filler. Of those, at least one selected from a glass fiber, a glass flake, and a milled fiber is preferred, and a glass fiber is the most preferred.

Suitable glass fibers are now described in more detail. The glass fiber used in the present invention has an effect of reinforcing a thermoplastic resinmoldedproduct while having a spinning property and mechanical strength comparable with fibers for reinforcing such as a conventional E-glass filler.

Glass fiber used in the present invention can be produced by any conventionally known spinningmethod for a continuous glass fiber. For example, it is possible to fibrillate glass by various methods such as the direct melt (DM) method in which a glass raw material is subjected to vitrification continuously in a melting furnace and then introduced to a forehearth, followed by spinning by a bushing mounted at the bottom of the forehearth, and the re-melting method in which molten glass is formed into a marble, cullet, or rod shape, followed by re-melting and spinning.

The diameter of the glass fiber is not particularly limited, but the diameter is preferably 5 to 50 µm. If the diameter is smaller than 5 µm, the contact area of the glass fiber and the resin is increased to cause irregular reflection, whereby the transparency of the molded product may deteriorate. If the diameter is larger than 50 µm, the strength of the glass fiber tends to be weak, with the result that the strength of the molded product may deteriorate. The diameter is more preferably 10 to 45 µm.

Glass powder can be produced by any conventionally known production method. For example, powders each having a desired particle size can be produced by a method in which a glass rawmaterial is melted in a melting furnace and put into water to perform water granulation, or by a method in which a glass raw material is melted in a melting furnace and the resultant melt is molded into a sheet on a cooling roll, followed by pulverization of the sheet. The particle size of the glass powder is not particularly limited, but the particle size is preferably 1 to 100 µm.

Glass flakes can be produced by any conventionally known production method. For example, flakes each having a desired aspect ratio can be produced by melting a glass raw material in a melting furnace, spinning the resultant melt into a tube shape, adjusting the thickness of the glass to a certain value, pulverizing the melt on a roll to prepare a frit having a specific thickness, and pulverizing the frit. The thickness and aspect ratio of the glass flake are not particularly limited but are preferably 0.1 to 10 µm and 5 to 150, respectively.

Milled fiber can be produced by any conventionally known production method for a milled fiber. For example, a milled fiber can be produced by pulverizing a strand of a glass fiber using a hammer mill or a ball mill. The fiber diameter and aspect ratio of the milled fiber are not particularly limited, but are preferably 5 to 50 µm and 2 to 150, respectively.

Glass beads can be produced by any conventionally known production method. For example, a glass bead having a desired particle size can be produced by melting a glass raw material in a melting furnace and spraying the melt with a burner. The particle size of the glass bead is not particularly limited, but is preferably 5 to 300 µm.

Further, as the glass filler of the present invention, a glass fiber, a glass powder, a glass flake, and a milled fiber, a glass bead, or the like each having the common glass composition may be combined and used as long as the performance as the cover material of the solar cell module is not impaired.

The glass filler may be surface-treated with a treatment containing a coupling agent, thereby increasing the affinity and the adhesiveness between the thermoplastic resin component and the glass filler, in order to suppress any deterioration in transparency of the molded product due to formation of voids.

As the coupling agent, silane coupling agents, borane coupling agents, aluminate coupling agents, titanate coupling agents, and the like may be used. In particular, because good adhesiveness between the thermoplastic resin and the glass filler can be obtained, silane coupling agents are preferred. As the silane coupling agents, aminosilane coupling agents, epoxysilane coupling agents, acrylsilane coupling agents, and the like may be used. Of those silane coupling agents, aminosilane coupling agents are most preferred.

Inaddition, the treatment may optionally comprise film formers, lubricating agents, antistatic agents, and the like, in addition to the coupling agent. Those components may be used singly, or a plurality of components may be used in combination. As the film former, a vinyl acetate resin, a urethane resin, an acrylic resin, a polyester resin, a polyether resin, a phenoxy resin, a polyamide resin, an epoxy resin, or the like may be used. As the lubricating agent, an aliphatic ester, aliphatic ether, aromatic ester, or aromatic ether surfactant may be used. As the antistatic agent, an inorganic salt such as lithium chloride or potassium iodide, as well as a quaternary ammonium salt such as an ammonium chloride type or an ammonium ethosulfate type salt, may be used.

In the present invention, the glass filler content in the thermoplastic resin molded product is preferably 5 to 40 mass%, and more preferably 5 to 20 mass%, based on the product. If the glass filler content is less than 5 mass%, the obtained thermoplastic resin molded product tends to have poor mechanical properties, while if the glass filler content exceeds 40 mass%, the contact area of the resin and the glass filler is increased, which tends to lower transparency of the obtained thermoplastic resin molded product and may lower moldability. When the amount of the glass filler in the thermoplastic resin molded product is within the above-mentioned range, it is possible to produce a molded product having both good mechanical properties and excellent transparency. The molded product is preferably used for a cover member of the solar cell module.

### (Production method for glass filler-containing thermoplastic resin molded product)

The glass filler-containing thermoplastic resin molded product of the present invention is obtained by molding a resin compound using any conventionally known molding method such as injection molding, extrusion molding, compression molding, or calender molding.

The res in compound can be produced by us ing a mixture containing a glass filler, a thermoplastic resin, and any optional additive(s) in any conventionally known method such as melt-kneading or a pultrusion molding method. The melt-kneading method is a method in which a molten resin, glass filler, and optional additive (s) are kneaded in an extruder. The melt-kneading method includes: a method including melting a resin in a twin screw extruder and feeding a glass filler from a feeding port (side-feed method); and a method in which a pre-blended mixture of resin, a glass filler, and optional additive(s) is melt-kneaded in a twin or single screw extruder (premix method) . In the side-feed method, any optional additive (s) may be preliminarily mixed wi th a resin or may be preliminarily mixed wi th a glass filler depending on the characteristics of the additive(s). Moreover, in order to suppress decomposition or change in color due to air-oxidation, any opening port and material-feeding port in the extruder may be set to a nitrogen atmosphere.

The pultrusion molding method is preferably employed in the case where the glass filler is in the form of a continuous glass fiber, and the molded product produced is required to have higher mechanical strength. The pultrusion molding method is a method in which a resin to be used as a matrix is impregnated in a consecutive continuous glass fiber bundle while the bundle is being stretched. Examples of the method include: a method including impregnating a resin by passing a fiber bundle through an impregnation bath filled with a matrix resin solution; a method including impregnating a molten matrix resin in a fiber bundle after attaching a matrix resin powder to a fiber bundle by spraying the matrix resin powder to the fiber bundle or by passing the fiber bundle through a bath filled with the powder; and a method including impregnating a matrix resin in a fiber bundle by supplying the resin to a crosshead from an extruder or the like while passing the fiber bundle through the crosshead. Of those, the method using the crosshead is preferable.

Production conditions for obtaining the resin compound and conditions for molding the resin compound and obtaining the glass filler-containing thermoplastic resinmoldedproduct can be selected appropriately and are not particularly limited. However, the heat temperature upon the melt-kneading and the resin temperature upon the injection molding are generally selected from a range preferably of 220°C to 300°C in order to suppress decomposition of the resin.

If the glass filler is present on the outermost surface of the molded product, the surface roughness of the product increases, which may increase irregular reflection on the surface of the molded product, possibly resulting in deteriorating transparency of the molded product. Therefore, in order to improve the transparency of the molded product, there may be employed a method including decreasing the surface roughness of the molded product by forming a layer containing a high ratio of resin (skin layer) on the outermost surface of the molded product. In order to form the skin layer, in the case of injection molding, the temperature of a mold may be adjusted to a temperature higher than that of general conditions (equal to or higher than a deflection temperature under load of a material). By the foregoing, the method can improve fluidity of the resin in contact with the mold to form the skin layer on the outermost surface of the molded product, which may decrease the surface roughness of the molded product. In order to prevent a suppression of flux of a molten resin caused by rapid cooling, when injected in a mold, the inner surface of the mold may be coated with a resin, or a sheet previously molded so as to follow the mold may be included (film-insert molding), or a continuous film may be attached to the surface of the mold before molding (film-in molding) . If the surface roughness decreases by forming the skin layer on the outermost surface of the molded product through the above-mentioned methods, irregular reflection decreases on the surface of the molded product to reduce the haze, whereby it is possible to improve the transparency of the molded product.

An antioxidant as an optional additive can suppress decomposition and coloring of the resin at the time of production or molding of the thermoplastic resin molded product. In addition, by using a colorant which does not impair the transparency, a colored, transparent molded product, which is suitable for a peak wavelength of a light-receiving device of the solar cell, can be obtained as a cover member, in particular, a front surface cover. On the other hand, the glass filler-containing thermoplastic resinmoldedproduct used in the rear surface cover member may include an additive for reflecting the light such as a pigment in order to reflect the entered sunlight to the solar cell side. Transparency and translucency of the thus obtained glass filler-containing thermoplastic resin molded product itself is deteriorated, but the amount of sunlight entered into the solar cell can be increased, resulting in possible improvement of the power generation efficiency.

In the case where the glass filler-containing thermoplastic resin molded product of the present invention thus produced is molded into a plate, the molded product should have a parallel light transmittance to visible light of 65% or more and a haze of less than 30%. The parallel light transmittance is preferably 70% or more. The haze is preferably 25% or less, and particularly preferably 20% or less. The glass filler-containing thermoplastic molded product having such optical properties is excellent in transparency and is useful for application which is required to have high transparency. Note that the parallel light transmittance to visible light may be measured in accordance with JIS-K7105. The haze may be measured in accordance with JIS-K7136.

A glass filler content and thickness of the glass filler-containing thermoplastic resin molded product of the present invention may be appropriately selected with a view to balancing the needed performance of the molded product, that is, optical characteristics such as transparency and mechanical properties such as a linear expansion coefficient.

The amorphous polyamide resin molded product has a difference in refractive indices between the resin component containing an amorphous polyamide resin and the glass filler of 0. 002 or less with respect to light having a wavelength of 589 nm, and preferably 0.002 or less with respect to light having a wavelength of 486 m, and 0.002 or less with respect to light having a wavelength of 656 nm. The differences in the refractive indices are more preferably 0.001 or less with respect to light having respective three wavelengths. Differences in refractive index between the resin component containing an amorphous polyamide resin and the glass filler exceeding 0.002 with respect to light having these wavelengths are not preferred, because the transparency of the amorphous polyamide resin molded product will be low.

### (Cover member)

The thickness of the cover member of the present invention using the glass filler-containing thermoplastic resin moldedproduct may be any suitable thickness. In particular, in the case of a molded product required to have transparency, the thickness should be adjusted to 0.1 to 5 mm, and more preferably 0.2 to 2 mm. If the thickness of the moldedproduct is less than 0.1 mm, the molded product warps easily and has low mechanical strength, which causes difficulty in molding. On the other hand, if the thickness of the molded product exceeds 5 mm, transparency is impaired.

In addition, a coating such as a hard coat film, antifog film, antistatic film, or antireflective film is preferably formed on the cover member. The coating may be a complex coating including two or more of the films.

The cover member is particularly preferably coated with a hard coat film because the coating has weather resistance and can prevent chronologic abrasion on the surface of the molded product. The material of the hard coat film is not particularly limited, and any knownmaterial such as an acrylate hard coating, silicone hard coating, or inorganic hard coating may be used.

### (Solar cell)

The solar cell used in the present invention is not particularly limited, and include a silicon solar battery, a compound semiconductor solar battery, an organic thin film solar battery, and dye sensitization type solar battery, and the like. Preferred is a solar cell having plasticity from a viewpoint of ease with which the solar cell is molded into a shape such as curve.

### (Solar cell module)

As shown in FIG. 1, the solar cell module of the present invention includes the front surface cover member 2 on a light receiving side into which the sunlight enters (front side), the rear surface cover member 3 on a side opposite to the light receiving side (rear side), and the solar cell 4 sealed between the front surface cover member 2 and the rear surface cover member 3 with the filler 5. As the filler, used is a resin having such a characteristic that the resin is cross linked at a lower temperature than a melting point of the thermoplastic resin used in the cover member, and an ethylene-vinyl acetate copolymer resin (EVA resin) or the like is preferably used.

The front surface cover member 2 is formed of the glass filler-containing thermoplastic resin molded product having transparency, and the molded product having a parallel light transmittance of 65% or more and a haze of less than 30 is applied to the front surface cover member 2. A material having the same components and thickness as the material of the front surface cover member is applied to the rear cover member. A certain pigment may be added to, particularly, the rear surface cover member in order to reflect the entered sunlight to the solar cell side.

Next, an example of a production method for a reference solar cell module is described. First, on a rear surface cover member having a thickness of about 1 mm and formed of a glass filler-containing polycarbonate resin molded product, a laminate sheet which is formed of an EVA resin, serves as a filler, and has a thickness of about 0.5 to 3 mm (hereinafter, referred to as EVA sheet) is disposed. Then, a solar cell is disposed on the first EVA sheet. Subsequently, a second EVA sheet which serves as a filler to cover the solar cell and has comparable thickness to the first EVA Sheet is disposed on the solar cell. In addition, on the second EVA sheet, a front surface cover member having the same thickness of about 1 mm as the rear surface cover member and formed of the glass filler-containing polycarbonate resin molded product is disposed. After that, heat treatment is conducted so that the first EVA sheet and the second EVA sheet are cured.

In this time, the EVA sheets are cured in the state where the solar cell 4 is interposed between the first EVA sheet and the second EVA sheet, with the result that the solar cell is sealed with the filler. Through the above processes, the solar cell module equipped with the solar cell shown in FIG. 1 is produced.

In the solar cell module described above, the front surface cover member has such a translucency that a parallel light transmittance is 65% or more and a haze is less than 30%, is lighter compared to a cover member formed of plate glass, and is easily molded in a curved shape. In addition, glass filler-containing thermoplastic resin moldedproducts each formed of the same component are used in the front surface cover member and the rear surface cover member, so the shrinkage by heat of the front surface cover member and the rear surface cover member are of the same order. Therefore, warp of the solar cell to one of the directions of the front side and the rear side upon the curing by heat of the EVA sheets can be suppressed.

Further, a glass filler-containing thermoplastic resin molded product having a linear expansion coefficient of 3.0 to 6.0 (× 10⁻⁵/°C) is applied as materials of the front surface cover member 2 and the rear surface cover member 3, whereby the linear expansion coefficient of the solar cell module can be kept low, and any linear expansion coefficient difference between the solar cell module and peripheral members can be minimised. As a result, when the solar cell module is incorporated in an exterior material of the vehicle, flexure and distortion can be suppressed.

Further, by setting the thickness of the front surface cover member 2 to the same thickness of the rear surface cover member 3, the shrinkage of the second EVA sheet in contact with the front surface cover member 2 is in the same level as that of the first EVA sheet in contact with the rear surface cover member 3. Accordingly, tension accompanied with the shrinkage of the EVA sheets is uniformly dispersed into the front surface side and the rear surface side of the solar cell module, and the warp of the solar cell module can be further suppressed.

As the resin in the glass filler-containing thermoplastic resin molded product used in the rear surface cover member 3, in addition to an amorphous polyamide resin, a polymethacrylic resin or a polyethylene terephthalate resin can be applied. As the glass filler, a glass filler having a refractive index that is different by 0.002 or less from that of resin can be used in accordance with the respective resin.

In addition, in the case where translucency is not essential for the rear surface cover member 3, a pigment such as a white pigment including silica is preferably added to the rear surface cover member 3. By making the rear surface cover member 3 white, for example, sunlight entering from a gap between the rear surface cover member 3 and the adjacent solar cell body 4 can be scattered or reflected on the rear surface cover member 3, to thereby contribute to electric power generation.

### Examples

Hereinafter, the present invention is described in detail by way of examples. However, those examples are intended to describe embodiments of the present invention and are not intended to limit the scope of the present invention.

### (Glass fiber)

Glass Fibers (GF1 to GF4) were prepared in the compositions (mass%) as shown in Table 1 below.

The glass fiber was spun to have a fiber diameter of 13 µm by a conventionally known method, and as a binder, aminosilane and urethane were attached thereto so as to be 0.5 mass%. Table 1 shows the compositions of the glass fibers, and refractive indices with respect to light having a wavelength of 589 nm (hereinafter, referred to as nD), with respect to light having a wavelength of 486 nm (hereinafter, referred to as nF), and with respect to light having a wavelength of 656 nm (hereinafter, referred to as nC). The refractive indices were measured by the immersion liquid method by B method disclosed in JIS-K7142.

| mass% | GF4 |
|---|---|
| SiO₂ | 71.0 |
| Al₂O₃ | 4.0 |
| B₂O₃ | 4.0 |
| CaO | 7.1 |
| MgO | 3.0 |
| ZnO | |
| BaO | |
| SrO | |
| Na₂O | 10.9 |
| K₂O | |
| TiO₂ | |
| ZrO₂ | |
| Total | 100.0 |

| Applied resin | GA |
|---|---|
| Refractive index | |
| nF | 1.515 |
| nD | 1.509 |
| nC | 1.507 |

### (Glass filler-containing amorphous polyamide resin molded product)

Compounding was performed by using Glass Fiber (GF4) in the following conditions, and the obtained resin compound was molded, whereby glass filler-containing amorphous polyamide resin molded products serving as Molded Products 1 and 2 were produced.

### (Amorphous polyamide resin used)

Amorphous Polyamide Resin (GA1) : Grilamid TR90 (manufactured by EMS-Chemie, nD = 1.509, nF = 1.516, nC = 1.506)

### (Compounding conditions)

· Glass fiber: a chopped strand having a diameter of 13 µm and a length of 3 mm, number of filaments in strand: 400
· Extruder: TEM-35B (manufactured by TOSHTBA MACHINE CO., LTD.)
· Extrusion temperature: 280°C
· Glass contents; 10 mass%, 20 mass%

### (Injection conditions)

· Molding machine: IS-80G (manufactured by TOSHIBA MACHINE CO., LTD.)
· Cylinder temperature: 280°C
· Mold temperature: 130°C

Note that an amorphous polyamide resin molded product as Reference Molded Product 1 was obtained using only an amorphous polyamide resin for comparison.

Table 2 shows the optical properties and mechanical properties of Molded Products 1 and 2 and Reference Molded Product 1 thus obtained. The parallel light transmittance, one of the optical properties, was measured in accordance with JIS-K7105 for a sample with a thickness of 2 mm using an NDH sensor manufactured by Nippon Denshoku Industries Co., Ltd. The haze value was measured according to JIS-K7136 for a sample with a thickness of 2 mm using an NDH sensor manufactured by Nippon Denshoku Industries Co., Ltd. Themechanical properties were measured for a sample with a thickness of 3 mm, while the flexural strength and the flexural modulus were measured in accordance with ASTM D-790. The tensile strength was measured in accordance with ASTM D-638. The deflection temperature under load (hereinafter, referred to as DTUL), which is an index of heat resistance, was measured in accordance with ASTM-D648. The linear expansion coefficient was measured in accordance with JIS K7197.

**(Table 2)**

| | | Test method | Unit | Molded Product 1 | Molded Product 2 | Reference Molded Product 1 |
|---|---|---|---|---|---|---|
| | Resin | | | GA1 | GA1 | GA1 |
| | Glass fiber | | | GF4 | GF4 | - |
| Difference of Refractive indices between resin and glass fiber | Wavelength 486 nm | | | 0.001 | 0.001 | |
| | Wavelength 589 nm | | | 0.000 | 0.000 | |
| | Wavelength 656 nm | | | 0.001 | 0.001 | |
| | Glass content | - | % | 10 | 20 | 0 |
| Optical properties (Plate thickness 2 mm) | Haze | JIS K 7136 | % | 7.9 | 20.3 | 1.3 |
| | Parallel light transmittance | JIS K 7105 | % | 83.5 | 71.2 | 90.8 |
| Mechanical properties (Plate thickness 3mm) | Tensile strength | ASTM D-638 | MPa | 67 | 91 | 56 |
| | Flexural strength | ASTM D-790 | MPa | 100 | 138 | 83 |
| | Flexural modulus | ASTM D-790 | MPa | 2,280 | 3,580 | 1,570 |
| | DTUL 1.81 MPa | ASTM D-648 | °C | 136 | 143 | 120 |
| | Linear expansion coefficient | JIS K 7197 | x 10⁻⁵/ °C | 5.7 | 4.6 | 8.3 |

### (Solar cell module)

A solar cell module was produced by the following method. First, on a rear surface cover member formed of the glass filler-containing amorphous polyamide resin molded product of Molded Product 1 and having a thickness of about 1 mm, a laminate sheet formed of the first EVA resin serving as a filler and having a thickness of about 1.5 mm (hereinafter, referred to as EVA sheet) was disposed. In addition, a solar cell formed of polycrystalline silicon was disposed on the first EVA sheet. Next, the second EVA sheet having the same thickness as the first EVA sheet was disposed thereon so as to cover the solar cell. A front surface cover member formed of the glass filler-containing amorphous polyamide resin molded product of Molded Product 1 and having a thickness of about 1 mm, which is the same material as in the rear surface cover member, was disposed on the second EVA sheet, whereby a laminate was obtained. The laminate was heated to 150°C under reduced pressure, whereby the first and second EVA sheets were cured to be used as fillers. As a result, the solar cell module of Example 1 was obtained.

In Comparative Example 1, a solar cell module of Comparative Example 1 was obtained by the same method as in Example 1 except that the amorphous polyamide resin molded product of Reference Molded Product 1 was used.

Environmental tests were performed for the thus obtained solar cell modules of Example 1 and Comparative Example 1. Here, the environmental tests were performed in accordance with JIS C8917 "Temperature-humidity cyclic test A-2", and the external appearance of the solar cell modules were evaluated by visual observation. No change in the external appearance was confirmed in the solar cell modules of Example 1, but peeling and warp were confirmed in the end parts of the solar cell modules of Comparative Example 1.

The solar module of the present invention can be used for dwellings, various landscape purposes, and to be mounted on vehicles. The solar cell module of the present invention, in particular, is thin, light, andeasilymoldedinacurveshape, therefore is favorably used for being mounted on moveable bodies such as automobiles.

## Claims

1. A solar cell module (1), comprising:
a front surface cover member (2) provided on a side into which sunlight enters;
a rear surface cover member (3) provided on a side opposite to the side into which sunlight enters to face the front surface cover member (2); and
a solar cell (4) provided between the front surface cover member (2) and the rear surface cover member (3), wherein:
the front surface cover member (2) and the rear surface cover member (3) are each formed of a glass filler-containing thermoplastic resin molded product; **characterized in that**:
the front surface cover member (2) comprises a glass filler-containing amorphous polyamide resin molded product including an amorphous polyamide resin and a glass filler, and having a difference in refractive indices between the amorphous polyamide resin and the glass filler of 0.002 or less with respect to light having a wavelength of 589 nm, and
wherein the glass filler in the glass filler-containing amorphous polyamide resin molded product in the front surface cover member (2) has a glass composition comprising, expressed in terms of oxides by mass%, 68 to 74% of silicon oxide (SiO₂), 2 to 5% of aluminum oxide (Al₂O₃), 2 to 5% of boron oxide (B₂O₃), 2 to 10% of calcium oxide (CaO), 0 to 5% of zinc oxide (ZnO), 0 to 5% of strontium oxide (SrO), 0 to 1% of barium oxide (BaO), 0 to 5% of magnesium oxide (MgO), 0 to 5% of lithium oxide (Li₂O), 5 to 12% of sodium oxide (Na₂O), and 0 to 10% of potassium oxide (K₂O), where:
a total content of the calcium oxide (CaO), the zinc oxide (ZnO), the strontium oxide (SrO), and the barium oxide (BaO) is 4 to 10%; and
a total content of the lithium oxide (Li₂O), the sodium oxide (Na₂O), and the potassium oxide (K₂O) is 8 to 12%.

2. A solar cell module (1) according to Claim 1, **characterized in that** the front surface cover member (2) has a parallel light transmittance of 65% or more and a haze of less than 30%.

3. A solar cell module (1) according to Claim 1 or Claim 2, **characterized in that** the glass filler-containing thermoplastic resin molded product has a linear expansion coefficient of 3.0 to 6.0 (x 10⁻⁵/°C).

4. A solar cell module (1) according to any preceding claim, **characterized in that** the rear surface covermember (3) also comprises a glass filler-containing amorphous polyamide resin molded product including an amorphous polyamide resin and a glass filler.

5. A solar cell module (1) according to Claim 4, **characterized in that** the glass filler in the glass filler-containing amorphous polyamide resin molded product in the rear surface cover member (3) has a glass composition comprising, expressed in terms of oxides by mass%, 68 to 74% of silicon oxide (SiO₂), 2 to 5% of aluminum oxide (Al₂O₃), 2 to 5% of boron oxide (B₂O₃), 2 to 10% of calcium oxide (CaO), 0 to 5% of zinc oxide (ZnO), 0 to 5% of strontium oxide (SrO), 0 to 1% of barium oxide (BaO), 0 to 5% of magnesium oxide (MgO), 0 to 5% of lithium oxide (Li₂O), 5 to 12% of sodium oxide (Na₂O), and 0 to 10% of potassium oxide (K₂O), where:
a total content of the calcium oxide (CaO), the zinc oxide (ZnO), the strontium oxide (SrO), and the barium oxide (BaO) is 4 to 10%; and
a total content of the lithium oxide (Li₂O), the sodium oxide (Na₂O), and the potassium oxide (K₂O) is 8 to 12%.

6. A solar cell module (1) according to any one of Claims 1 to 5, **characterized in that** the glass filler comprises at least one selected from the group consisting of a glass fiber, a glass flake, and a milled fiber.

7. A solar cell module (1) according to any one of Claims 1 to 6, which is used as an exterior device on a vehicle.

## Patentansprüche

1. Solarzellenmodul (1), umfassend:
ein Vorderflächenabdeckelement (2), das auf einer Seite vorgesehen ist, in die Sonnenlicht eintritt;
ein Rückflächenabdeckelement (3), das auf einer Seite, gegenüberliegend der Seite, in die Sonnenlicht eintritt, vorgesehen ist, sodass es zum Vorderflächenabdeckelement (2) weist; und
eine Solarzelle (4), die zwischen dem Vorderflächenabdeckelement (2) und dem Rückflächenabdeckelement (3) vorgesehen ist, wobei:
das Vorderflächenabdeckelement (2) und das Rückflächenabdeckelement (3) jeweils aus einem Formteil aus glasfüllstoffhaltigem thermoplastischem Harz ausgebildet sind; **dadurch gekennzeichnet, dass**:
das Vorderflächenabdeckelement (2) ein Formteil aus glasfüllstoffhaltigem amorphem Polyamidharz umfasst, das ein amorphes Polyamidharz und einen Glasfüllstoff umfasst, wobei die Differenz der Brechungsindizes des amorphen Polyamidharzes und des Glasfüllstoffs in Bezug auf Licht mit einer Wellenlänge von 589 nm 0,002 oder weniger beträgt und
wobei der Glasfüllstoff in dem Formteil aus glasfüllstoffhaltigem amorphem Polyamidharz im Vorderflächenabdeckelement (2) eine Glaszusammensetzung aufweist, die, ausgedrückt in Oxiden und Masse-%, umfasst: 68 bis 74 % Siliciumoxid (SiO₂), 2 bis 5 % Aluminiumoxid (Al₂O₃), 2 bis 5 % Boroxid (B₂O₃), 2 bis 10 % Calciumoxid (CaO), 0 bis 5 % Zinkoxid (ZnO), 0 bis 5 % Strontiumoxid (SrO), 0 bis 1 % Bariumoxid (BaO), 0 bis 5 % Magnesiumoxid (MgO), 0 bis 5 % Lithiumoxid (Li₂O), 5 bis 12 % Natriumoxid (Na₂O) und 0 bis 10 % Kaliumoxid (K₂O), wobei:
ein Gesamtgehalt des Calciumoxids (CaO), des Zinkoxids (ZnO), des Strontiumoxids (SrO) und des Bariumoxids (BaO) 4 bis 10 % beträgt; und
ein Gesamtgehalt des Lithiumoxids (Li₂O), des Natriumoxids (Na₂O) und des Kaliumoxids (K₂O) 8 bis 12 % beträgt.

2. Solarzellenmodul (1) nach Anspruch 1, **dadurch gekennzeichnet, dass** das Vorderflächenabdeckelement (2) eine parallele Lichtdurchlässigkeit von 65 % oder mehr und eine Trübung von weniger als 30 % aufweist.

3. Solarzellenmodul (1) nach Anspruch 1 oder Anspruch 2, **dadurch gekennzeichnet, dass** das Formteil aus glasfüllstoffhaltigem thermoplastischem Harz einen linearen Ausdehnungskoeffizienten von 3,0 bis 6,0 (x 10⁻⁵/°C) aufweist.

4. Solarzellenmodul (1) nach einem vorangehenden Anspruch, **dadurch gekennzeichnet, dass** das Rückflächenabdeckelement (3) ebenfalls ein Formteil aus glasfüllstoffhaltigem amorphem Polyamidharz umfasst, das ein amorphes Polyamidharz und einen Glasfüllstoff umfasst.

5. Solarzellenmodul (1) nach Anspruch 4, **dadurch gekennzeichnet, dass** der Glasfüllstoff in dem Formteil aus glasfüllstoffhaltigem amorphem Polyamidharz im Rückflächenabdeckelement (3) eine Glaszusammensetzung aufweist, die, ausgedrückt in Oxiden und Masse-%, umfasst: 68 bis 74 % Siliciumoxid (SiO₂), 2 bis 5 % Aluminiumoxid (Al₂O₃), 2 bis 5 % Boroxid (B₂O₃), 2 bis 10 % Calciumoxid (CaO), 0 bis 5 % Zinkoxid (ZnO), 0 bis 5 % Strontiumoxid (SrO), 0 bis 1 % Bariumoxid (BaO), 0 bis 5 % Magnesiumoxid (MgO), 0 bis 5 % Lithiumoxid (Li₂O), 5 bis 12 % Natriumoxid (Na₂O) und 0 bis 10 % Kaliumoxid (K₂O), wobei:
ein Gesamtgehalt des Calciumoxids (CaO), des Zinkoxids (ZnO), des Strontiumoxids (SrO) und des Bariumoxids (BaO) 4 bis 10 % beträgt; und
ein Gesamtgehalt des Lithiumoxids (Li₂O), des Natriumoxids (Na₂O) und des Kaliumoxids (K₂O) 8 bis 12 % beträgt.

6. Solarzellenmodul (1) nach einem der Ansprüche 1 bis 5, **dadurch gekennzeichnet, dass** der Glasfüllstoff mindestens eines ausgewählt aus der Gruppe bestehend aus einer Glasfaser, einer Glasflocke und einer Kurzfaser umfasst.

7. Solarzellenmodul (1) nach einem der Ansprüche 1 bis 6, das als externe Vorrichtung auf einem Fahrzeug verwendet wird.

## Revendications

1. Module de cellule solaire (1), comprenant :
un organe de couvercle de surface avant (2) disposé sur un côté dans lequel la lumière du soleil pénètre ;
un organe de couvercle de surface arrière (3) disposé sur un côté opposé au côté dans lequel la lumière du soleil pénètre pour faire face à l'organe de couvercle de surface avant (2) ; et
une cellule solaire (4) disposée entre l'organe de couvercle de surface avant (2) et l'organe de couvercle de surface arrière (3), dans lequel :
l'organe de couvercle de surface avant (2) et l'organe de couvercle de surface arrière (3) sont chacun formés d'un produit moulé en résine thermoplastique contenant une charge de verre ; **caractérisé en ce que** :
l'organe de couvercle de surface avant (2) comprend un produit moulé en résine polyamide amorphe contenant une charge de verre incluant une résine polyamide amorphe et une charge de verre, et ayant une différence d'indices de réfraction entre la résine polyamide amorphe et la charge de verre de 0,002 ou moins par rapport à la lumière ayant une longueur de 589 nm, et
dans lequel la charge de verre dans le produit moulé en résine polyamide amorphe contenant une charge de verre dans l'organe de couvercle de surface avant (2) a une composition de verre comprenant, exprimée en termes d'oxydes en % en masse, 68 à 74 % d'oxyde de silicium (SiO₂), 2 à 5 % d'oxyde d'aluminium (Al₂O₃), 2 à 5 % d'oxyde de bore (B₂O₃), 2 à 10 % d'oxyde de calcium (CaO), 0 à 5 % d'oxyde de zinc (ZnO), 0 à 5 % d'oxyde de strontium (SrO), 0 à 1 % d'oxyde de baryum (BaO), 0 à 5 % d'oxyde de magnésium (MgO), 0 à 5 % d'oxyde de lithium (Li₂O), 5 à 12 % d'oxyde de sodium (Na₂O) et 0 à 10 % d'oxyde de potassium (K₂O), où :
une teneur totale en oxyde de calcium (CaO), oxyde de zinc (ZnO), oxyde de strontium (SrO) et oxyde de baryum (BaO) est de 4 à 10 % ; et
une teneur totale en oxyde de lithium (Li₂O), oxyde de sodium (Na₂O) et oxyde de potassium (K₂O) est de 8 à 12 %.

2. Module de cellule solaire (1) selon la revendication 1, **caractérisé en ce que** l'organe de couvercle de surface avant (2) a une transmittance de lumière parallèle de 65 % ou plus et un voile inférieur à 30 %.

3. Module de cellule solaire (1) selon la revendication 1 ou la revendication 2, **caractérisé en ce que** le produit moulé en résine thermoplastique contenant une charge de verre a un coefficient de dilatation linéaire de 3,0 à 6,0 (x 10⁻⁵/°C).

4. Module de cellule solaire (1) selon l'une quelconque des revendications précédentes, **caractérisé en ce que** l'organe de couvercle de surface arrière (3) comprend également un produit moulé en résine polyamide amorphe contenant une charge de verre incluant une résine polyamide amorphe et une charge de verre.

5. Module de cellule solaire (1) selon la revendication 4, **caractérisé en ce que** la charge de verre dans le produit en résine polyamide amorphe contenant une charge de verre dans l'organe de couvercle de surface arrière (3) a une composition de verre comprenant, exprimée en termes d'oxydes en % en masse, 68 à 74 % d'oxyde de silicium (SiO₂), 2 à 5 % d'oxyde d'aluminium (Al₂O₃), 2 à 5 % d'oxyde de bore (B₂O₃), 2 à 10 % d'oxyde de calcium (CaO), 0 à 5 % d'oxyde de zinc (ZnO), 0 à 5 % d'oxyde de strontium (SrO), 0 à 1 % d'oxyde de baryum (BaO), 0 à 5 % d'oxyde de magnésium (MgO), 0 à 5 % d'oxyde de lithium (Li₂O), 5 à 12 % d'oxyde de sodium (Na₂O) et 0 à 10 % d'oxyde de potassium (K₂O), où :
une teneur totale en oxyde de calcium (CaO), oxyde de zinc (ZnO), oxyde de strontium (SrO) et oxyde de baryum (BaO) est de 4 à 10 % ; et
une teneur totale en oxyde de lithium (Li₂O), oxyde de sodium (Na₂O) et oxyde de potassium (K₂O) est de 8 à 12 %.

6. Module de cellule solaire (1) selon l'une quelconque des revendications 1 à 5, **caractérisé en ce que** la charge de verre comprend au moins un élément choisi dans le groupe constitué d'une fibre de verre, d'un flocon de verre et d'une fibre broyée.

7. Module de cellule solaire (1) selon l'une quelconque des revendications 1 à 6, qui est utilisé comme dispositif extérieur sur un véhicule.
